Europäisches Patentamt

European Patent Office

Office européen des brevets

(11) Publication number : **0 474 508 A2**

# (12) EUROPEAN PATENT APPLICATION

(21) Application number : 91308176.6

(22) Date of filing : 06.09.91

(51) Int. Cl.⁵ : **G02F 1/13,** H01L 21/60

(30) Priority : **07.09.90 JP 237350/90**

(43) Date of publication of application :
**11.03.92 Bulletin 92/11**

(84) Designated Contracting States :
**DE FR GB**

(71) Applicant : **SEIKO EPSON CORPORATION**
**4-1, Nishishinjuku 2-chome**
**Shinjuku-ku Tokyo (JP)**

(72) Inventor : **Seiichi, Sakura**
**c/o Seiko Epson Corporation, 3-5, Owa**
**3-chome**
**Suwa-shi, Nagano-ken (JP)**
Inventor : **Kamimura, Masaru**
**c/o Seiko Epson Corporation, 3-5, Owa**
**3-chome**
**Suwa-shi, Nagano-ken (JP)**

(74) Representative : **Miller, Joseph et al**
**J. MILLER & CO. Lincoln House 296-302 High**
**Holborn**
**London WC1V 7JH (GB)**

(54) **Liquid crystal display device and mounting arrangement therefor.**

(57)    The present invention provides a liquid crystal display device comprising a liquid crystal display member (3), which includes a pair of opposed glass substrates having transparent electrodes on their inner surfaces and a liquid layer between the opposed glass substrates, a drive control circuit mounted on a board (4) for controlling the liquid crystal display member, and a driving IC (2) for driving the liquid crystal display member, characterised in that the driving IC is mounted on the liquid crystal display member so as to face the drive control circuit board, and in that the drive control circuit is connected by wiring (5) to the liquid crystal display member for supplying an input to the driving IC for driving the liquid crystal display member.

FIG. 1

The present invention relates to a liquid crystal display device, and to a mounting arrangement by which a liquid crystal display member, a drive control circuit board and a driving IC are connected together.

In liquid crystal display devices, flexible connection members supporting IC chips, such as LSIs, for driving a liquid crystal display member of the device are widely used for the purpose of providing an electrical connection between a drive control circuit board of the display device and the liquid crystal display member.

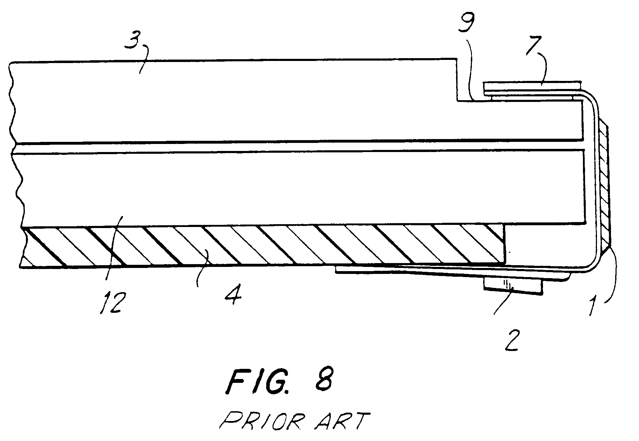

Figure 8 shows an example of such a liquid crystal display device, which employs a flexible connection member. In this figure, a flexible connection member 1, such as a so called FPC (Flexible Printed Circuit), provides a connection between a drive control circuit board 4 and a liquid crystal display member 3. Driving IC chips 2, such as LSIs, are mounted on the flexible connection member 1 by so called TAB (Tape Automated Bonding) for driving the liquid crystal display member.

More especially, an input end of an inner lead portion of the flexible connection member 1 is connected by, for example, soldering to the drive control circuit board, whereas an output end of the same is connected to an electrode substrate 9 of the liquid crystal display member 3 through an anisotropic conductive bond 7.

In a liquid crystal display device incorporating a flexible connection member of the kind described, the wiring (copper foil) thickness of the inner lead portion of the flexible connection member 1 is 35 µm or so, and 32 to 320 wires are arranged at a wiring pitch of 100 µm to 200 µm. Since the wires are very thin and the wiring pitch is very small, the wires often tend to be bent or broken during production, which impairs the yield. In addition, it has hitherto been impossible to reduce the wiring pitch to a level below 100 µm.

In current liquid crystal display devices, there is a trend towards finer electrode patterns as a result of increases in the number of electrodes needed on an electrode substrate, in order to cope with the demands for colour display, higher image density and compact construction. This inevitably requires a finer arrangement of the input/output wires of the flexible connection member, and in particular a smaller pitch for the output wires. Unfortunately, however, conventional flexible connection members cannot cope with the demand for refining the electrode patterns to a level below 100 µm.

Furthermore, since the input end of the flexible connection member 1 is placed under the drive control board 4 when the flexible connection member is connected to the liquid crystal display member 3 by the anisotropic conductive bond, the thickness of the liquid crystal display device is increased by an amount corresponding either to the thickness of the flexible connection member 1 or to the combined thicknesses of the driving IC chip 2 and the flexible connection member 1.

Accordingly, it is an object of the present invention to provide a drive circuit mounting arrangement for apparatus, such as a liquid crystal display device, which can cope with the demands for refining the electrode pattern and for more compact construction and which offers improved reliability and durability.

According to the present invention, there is provided a liquid crystal display device comprising a liquid crystal display member, which includes a pair of opposed glass substrates having transparent electrodes on their inner surfaces and a liquid layer between the opposed glass substrates, a drive control circuit mounted on a board for controlling the liquid crystal display member, and a driving IC for driving the liquid crystal display member, characterised in that the driving IC is mounted on the liquid crystal display member so as to face the drive control circuit board, and in that the drive control circuit is connected by bonded wiring to the liquid crystal display member for supplying an input to the driving IC for driving the liquid crystal display member.

In one embodiment of the invention, the drive control circuit board is cut away except for a join portion so as to form a wiring opening to allow for the passage of the input wiring for the driving IC, the wiring opening being arranged to enable bonding of the input wiring to the drive control circuit board and to the liquid crystal display member to be conducted in the same direction.

In another embodiment of the invention, a mould for protecting the driving IC fills the gap between the driving IC and the drive control circuit board and forms a bond with the drive control circuit board.

The present invention will be described further, by way of example, with reference to the accompanying drawings, in which:

Figures 1 to 4 are vertical sections, respectively, through different embodiments of the present invention;

Figure 5 is a plan view of a video camera view-finder incorporating the present invention;

Figures 6 and 7 are side views of the video camera view-finder of figure 5 taken from a common side and from a segment side, respectively; and

Figure 8 is a vertical section through a conventional liquid crystal display device.

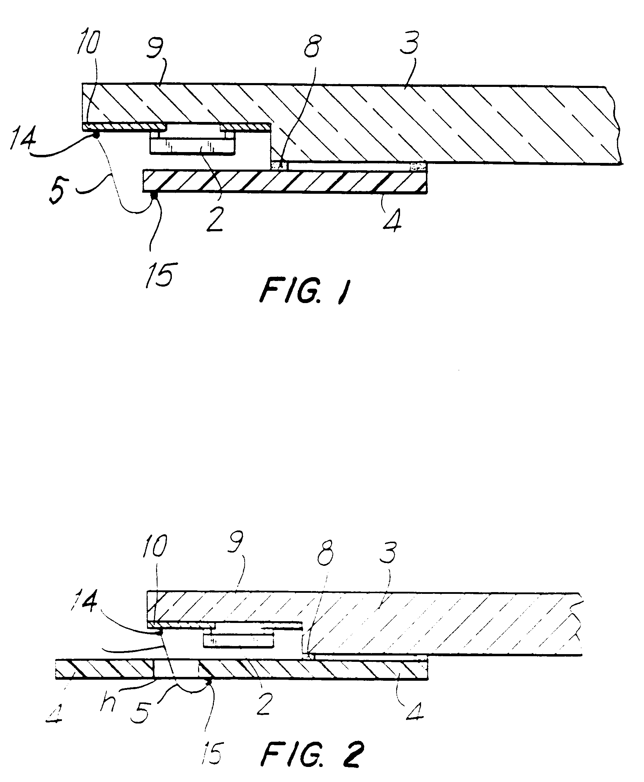

Figure 1 is a vertical section through a first embodiment of a liquid crystal display device according to the present invention. In this and subsequent figures, the same reference numerals are used to denote those parts having the same functions as corresponding parts of the conventional device described above, and a full description of such parts is omitted.

Referring to figure 1, a liquid crystal display device has a liquid crystal display member 3, which includes a pair of opposed glass substrates having transparent electrodes on their inner surfaces and a liquid crystal layer between the opposed glass substrates. The liquid crystal display device further has a control element, such as a drive control circuit board 4, for controlling the liquid crystal display member 3, and a driving IC 2 for driving the liquid crystal display member 3.

The driving IC 2 has input terminals at one side edge thereof and output terminals at an opposite side edge thereof. The output terminals of the driving IC 2 are aligned with transparent electrodes 10 on an electrode substrate 9 of the liquid crystal display member 3 and are connected thereto by face-down mounting of the driving IC 2 on the liquid crystal display member 3 in a position wherein the driving IC 2 faces the drive control circuit board 4. Input wires 14 for supplying signals to the input terminals of the driving IC 2 for driving the liquid crystal display member 3 are electrically connected by bonded wiring 5 to connection terminals 15 of the drive control circuit board 4.

The drive control circuit board 4 is connected to a portion of the liquid crystal display member 3 by a bond 8.

Figure 2 is a vertical section through a modification of the first embodiment and shows a mounting arrangement in which the drive control circuit board 4 has a size such that it extends beyond the liquid crystal display member 3. In order to enable bonding of the wiring 5 to the input wires 14 of the driving IC 2 mounted on the electrode substrate 9 of the liquid crystal display member 3, the drive control circuit board 4 is partly cut away so as to form a wiring opening h having a width large enough to receive a capillary or tool for wire bonding, whilst at the same time leaving joining portions at edges of the drive control circuit board 4. A capillary is passed through this opening h so that bonding of the wiring 5 to the drive control circuit board 4 and to the input wires 14 of the driving IC 2 may be effected in the same direction. The drive control circuit board 4 is also fixed to a part of the liquid crystal display member 3 in this case.

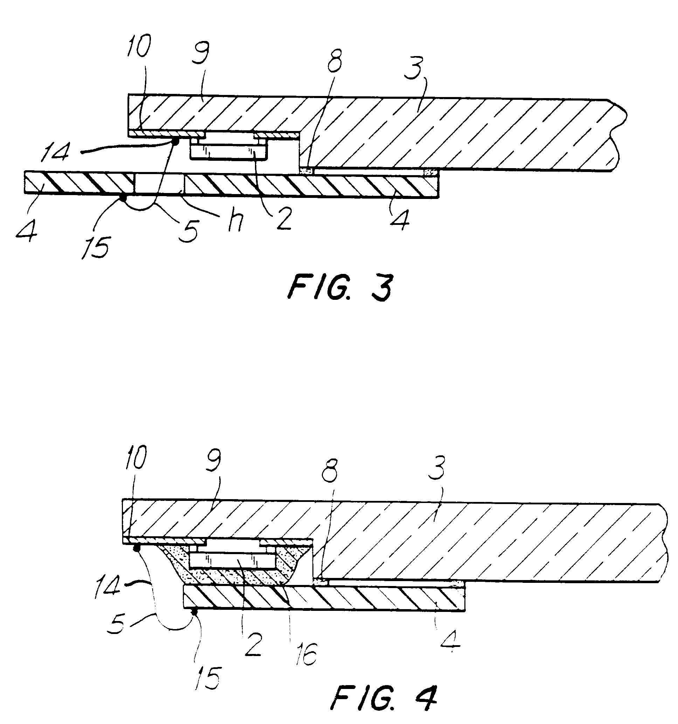

A further modification, in which the position of the bonded wiring 5 shown in figure 2 is altered, is illustrated in figure 3. The bonded wiring 5 in this instance is joined to the drive control circuit board 4 at a position beyond the edge of the liquid crystal display member 3.

Referring to figure 4, a further embodiment is shown, in which a mould agent 16 is applied to the driving LC 2 by means of a dispenser (not shown), and the drive control circuit board 4 is placed thereon, whereby the drive control circuit board 4 is fixed to the liquid crystal display member 3 by way of the bond 8 and the mould agent 16. In addition, the mould agent 16 protects the driving IC 2 and prevents the drive control circuit board 4 from being deformed in response to pressure generated when the wiring 5 is bonded to the connection terminals 15 on the drive control circuit board 4. Thus, the mould agent 16 plays a double role. Preferably, a material having a good affinity and bonding strength, eg a silicon resin or an epoxy resin, is used as the mould agent 16.

The driving IC shown in figures 1 to 4 has outer dimensions of 11.3 mm x 2.7 mm and is equipped with 160 output terminals. The inner lead pitch and the outer lead pitch are 65 μm and 80 μm, respectively. The liquid crystal display member 3 has a glass thickness of 1.1 mm.

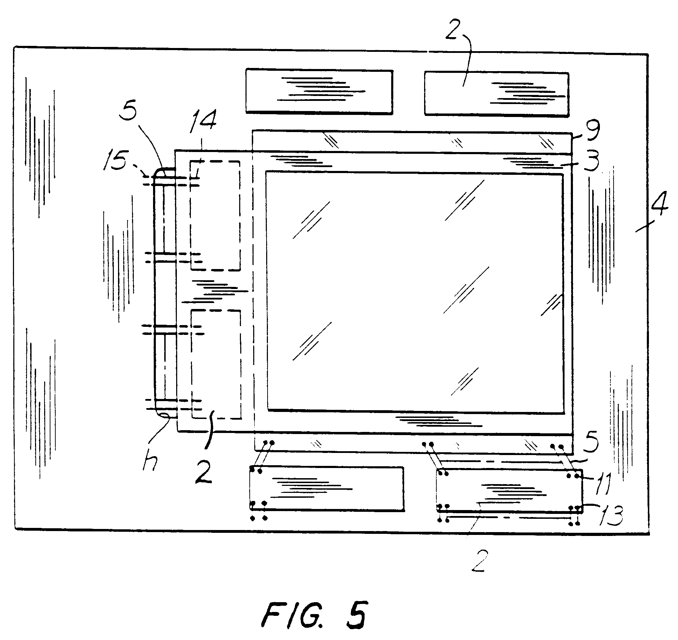

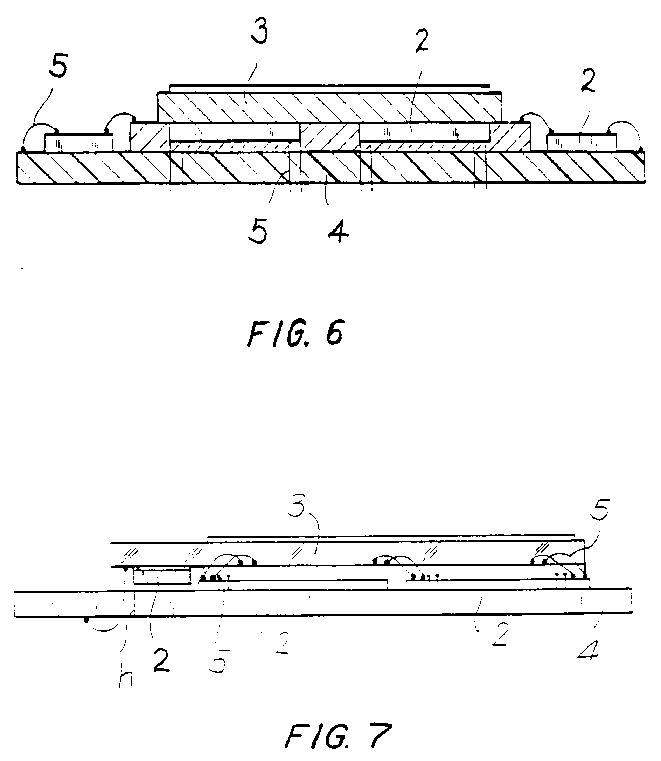

Figures 5, 6 and 7 show an embodiment of the mounting arrangement applied to a view-finder of a video camera.

The video camera view-finder shown in these figures has outer dimensions of 50 mm x 28 mm, and the liquid crystal display member 3 incorporated therein has outer dimensions of 26 mm x 19.5 mm. The display capacity is 360 x 220 dots and the dot pitch is 0.06 mm x 0.065 mm. The view-finder includes a plurality of the driving ICs 2, whose inner lead pitch is 65 μm. The input terminals of each driving IC 2 are at one side edge thereof and the output terminals are at an opposite side edge thereof. A wiring opening h is provided, whose dimensions are 1.8 mm x 15.5 mm.

As will be seen from these figures, the driving ICs 2 for scanning electrodes, on a common side of the view-finder, are face-down mounted on the electrode substrate 9 of the liquid crystal display member 3, and electrical connection between the connection terminals 15 and the input wires 14 is attained by the bonded wiring 5.

On the other hand, the driving ICs 2 for signal electrodes on a segment side of the view-finder, are mounted directly on the drive control circuit board 4. Bonded wiring 5 in this latter instance provides electrical connection between connection terminals on the drive control circuit board 4 and input terminals 13 of the driving ICs 2 and between output terminals 11 of the driving ICs 2 and terminals 17 on the electrode substrate 9. Although only parts of both ends of the bonded wiring 5 are shown, it will be understood that, in the actual view-finder, the number of such wires corresponds to the number of outputs of each driving IC 2.

Although the use of the invention in a liquid crystal display device has been specifically described, it is to be understood that the invention can be applied to other types of apparatus, such as plasma display apparatus, EL display apparatus, thermal print heads, and so forth.

The present invention enables an OLB (outer lead bonding) of a fine pattern of 100 μm or less to be obtained, by virtue of the connections between the input terminals 14 on the electrode substrate 9 of the liquid crystal display member 3 and the driving ICs 2 and between the driving ICs 2 and the drive control circuit board 4 accomplished by wire bonding or face-down mounting. In addition, the thickness of the liquid crystal display device can be reduced. It is therefore possible to obtain a display device in which the requirements for finer circuit patterning and more compact construction are satisfied and which is superior both in relability and durability.

## Claims

1. A liquid crystal display device comprising a liquid crystal display member (3), which includes a pair of opposed glass substrates having transparent electrodes on their inner surfaces and a liquid layer between the opposed glass substrates, a drive control circuit mounted on a board (4) for controlling the liquid crystal display member, and a driving IC (2) for driving the liquid crystal display member, characterised in that the driving IC is mounted on the liquid crystal display member so as to face the drive control circuit board, and in that the drive control circuit is connected by bonded wiring (5) to the liquid crystal display member for supplying an input to the driving IC for driving the liquid crystal display member.

2. A display device according to claim 1 characterised in that the drive control circuit board is formed with an opening (h) for receiving the input wiring for the driving IC, the opening being arranged to enable bonding of the input wiring to the drive control circuit board and the liquid crystal display member to be conducted in the same direction.

3. A display device according to claim 1 or 2 characterised in that the driving IC is encased within a protective mould, which fills the gap between the driving IC and the drive control circuit board and which forms a bond with the drive control circuit board.

4. A drive circuit mounting structure of an apparatus such as, for example, a liquid crystal display apparatus of the type which has a liquid crystal display body (3) including a pair of glass substrates having transparent electrodes on their inner surfaces and a liquid crystal charged between said glass substrates, a control member (4) such as a drive control circuit board for controlling said liquid crystal display body, and a driving IC (2) having an input on one side thereof and an output on the opposite side thereof, said mounting structure characterised in that the output wiring between said liquid crystal display body and said driving IC is mounted by face-down mounting an the input wiring between the liquid crystal display body in the drive control circuit board is mounted by wire bonding (5).

FIG. 1

FIG. 2

FIG. 3

FIG. 4

**FIG. 5**

**FIG. 6**

**FIG. 7**

*FIG. 8*

PRIOR ART